# EUROPEAN PATENT SPECIFICATION

(11) **EP 0 498 445 B1**
(45) Date of publication and mention of the grant of the patent: **26.05.1999**
(21) Application number: 92102064.0
(22) Date of filing: 07.02.1992
(51) Int. Cl.: G03F 1/00, B65D 81/02

(54) **Case for photomask**
Behälter für Photomaske
Etui pour photomasque

(30) Priority: 07.02.1991 JP 4455/91
(43) Date of publication of application: 12.08.1992
(73) Proprietor: DAI NIPPON PRINTING CO., LTD., Tokyo 162 (JP)
(72) Inventor: Tabuchi, Kazuhiro, c/o Dai Nippon Print.Co.Ltd., Tokyo 162 (JP); Yamauchi, Takashi, c/o Dai Nippon Print.Co.Ltd., Tokyo 162 (JP); Inomata, Hiroyuki, c/o Dai Nippon Print.Co.Ltd., Tokyo 162 (JP)
(74) Representative: VOSSIUS & PARTNER

(56) References cited:
- GB-A- 637 630
- GB-A- 1 030 546
- US-A- 3 850 296
- IBM TECHNICAL DISCLOSURE BULLETIN vol. 23, no. 11, April 1981, NEW YORK, US; pages 4934-4935; COOK ET AL.: 'LIGHT-WEIGT CLEANABLE MASK CONTAINER'
- PATENT ABSTRACTS OF JAPAN vol. 013, no. 0434 (M-875) 28 September 1989 & JP-A-1 167 075

## Description

The present invention relates to a case for accommodating and transporting a photomask or a substrate for photomask (hereinafter simply referred as "photomask") to be used in photolithography process for the manufacture of semiconductor devices such as LSI, ultra LSI, etc.

In the past, a photomask was accommodated directly in a case or accommodated and transported in a case using a buffer material of a polyvinyl chloride bag inflated by gas or a polyvinyl chloride bag containing sponge. Further, the photomask accommodated in a case was pressed down by providing a cushion material such as sponge within upper lid of the case. As such cushion material, a material containing a moisture-resistant substance such as silica gel has been used due to difference in rinsing method of photomask or in sealing property of the case.

However, when the photomask is accommodated directly in a case, there is a free space between the case and the photomask and this causes shaky movement or rattling, and dust is generated during transport accordingly. As the result, the photomask or a pellicle membrane to cover the photomask (hereinafter referred as "photomask pellicle") is contaminated. When the photomask is accommodated in a case using a polyvinyl chloride bag inflated by gas or a polyvinyl chloride bag as a buffer material containing a material such as sponge, the bag may be broken by impact during transport or foreign objects may spread in the bag. Further, when the case is opened, the polyvinyl chloride bag may not be held integrally with upper lid of the case and may fall onto the photomask which is exposed at upper portion of the case. As the result, flaw or stain may be caused on the surface of the photomask or the photomask pellicle because of lack of sealing between upper lid and polyvinyl chloride bag.

Also, when a cushion material such as sponge is provided, the shaking of the photomask during trans-portion cannot be perfectly prevented because the cushion material is provided only in the upper lid of the case and it is in contact only with one side of the photomask, and a similar problem occurs due to dusting from the portions between the case bottom or the case side and the photomask. There is another problem, which is caused by falling of the cushion material when the upper lid is opened or closed.

IBM Technical Disclosure Bulletin, Vol. 23, No. 11, April 1981, describes a container for the storage of light-sensitive glass masks. The container has a bottom outside case mating with a top outside case. A bottom inside liner is provided in the bottom outside case. A foam cushion is provided between the bottom end of the liner and the case. A cooperating top inside liner is provided in the top outside case. A foam cushion element is disposed between the liner and the top outside case.

It is the object underlying the present invention to provide an improved case for photomasks.

This object is achieved with a case according to the claims.

It is an advantage of the present invention to provide a case for a photomask using cushion materials which does not generate dust or gas in the case and which does not fall even when upper lid is opened or closed. According to the present invention cushion materials are furnished between the case and the photomask to prevent shaking or rattling and to minimize the generation of dust and the like to attach and stain the photomask or photomask pellicle.

The case for a photomask according to the present invention comprises a case main unit with an upper opening for accommodating the photomask or a photomask substrate and a lid for the opening of the case main unit, and it is characterized in that cushion materials are provided on inner bottom of the case main unit and on inner ceiling of the lid, and the photomask or the photomask substrate is elastically squeezed between cushion materials.

In this case, as the cushion materials, it is preferable to use rubber material, which possesses elasticity in itself and which does not cause changes such as stains, blur, etc. on the photomask, photomask substrate and photomask pellicle, and silicone rubber or fluoro-rubber are suitable for this purpose. Further, it is also preferable to smoothen the surface of the cushion material on inner ceiling of the lid facing internal surface of the lid and to coarsen the surface touching the photomask or the photomask substrate, or to attach a single-sided tape made of a material not adherent to glass on its surface in order to prevent the falling of the cushion materials when the lid is opened or closed.

In the present invention, cushion materials are provided on inner bottom of the case main unit and inner ceiling of the lid to accommodate the photomask and the photomask substrate by squeezing them between the cushion materials. This makes it possible to prevent the adhesion of dust and staining of the photomask and the photomask pellicle due to shaking and rattling between the case and the photomask during transportation.

Still other objects and advantages of the invention will in part be obvious and will in part be apparent from the specification.

The invention accordingly comprises the features of construction, combinations of elements, and arrangement of parts which will be exemplified in the construction hereinafter set forth, and the scope of the invention will be indicated in the claims.

### BRIEF DESCRIPTION OF THE DRAWINGS

Fig. 1 is a perspective view of an embodiment of the present invention, showing a photomask inserted into grooves of a case main unit;
Fig. 2 is a longitudinal cross-sectional view of the case main unit of Fig. 1 covered with an upper lid; and

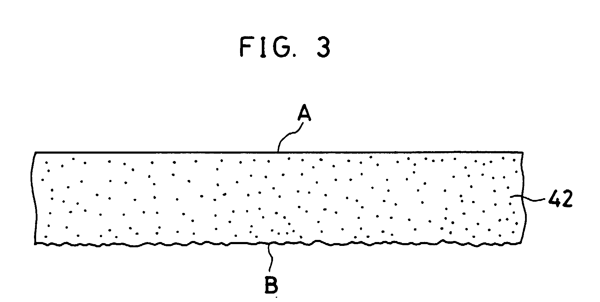

Fig. 3 is a cross-sectional view of a cushion material.

### DESCRIPTION OF THE PREFERRED EMBODIMENT

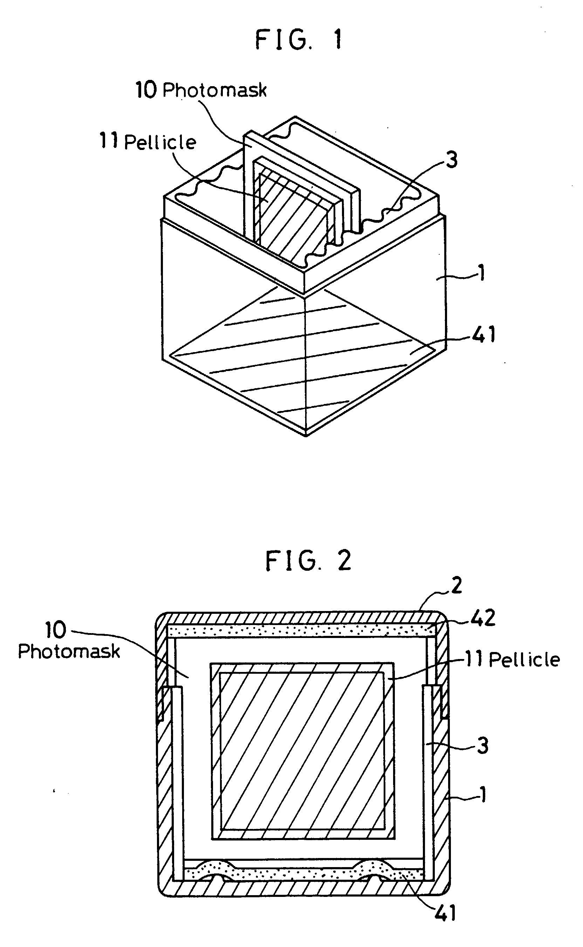

In the following, description will be given on an embodiment of a case for photomask according to the present invention, referring to the attached drawings. Fig. 1 is a perspective view showing a photomask 10 with a pellicle 11 inserted into grooves of a case main unit 1 from above, and Fig. 2 is a longitudinal cross-sectional view of the case main unit 1 of Fig. 1 covered with an upper lid 2. The shapes of the case main unit 1 and the upper lid 2 are the same as those of a conventional type case. On inner surfaces opposing to each other of the case main unit 1, partitions 3 are provided to form grooves, into which the photomask 10 is to be inserted.

On inner bottom of the case main unit 1 and on inner ceiling of the upper lid 2, cushion materials 41 and 42 are provided, and a photomask 10 is accommodated between them as if squeezed therebetween. As the result, shaking and rattling of the photomask 10 during transportation are minimized and the generation of dust due to such shaking is prevented. As the cushion materials 41 and 42, materials such as silicone rubber, fluoro-rubber, etc. are used, which have elasticity in themselves, do not require cushion effect by gas such as air and do not generate dust or gas due to breaking of air bubbles. Such rubber material does not cause changes such as stain, blur, etc. on the photomask and the photomask pellicle and should be resistant to repeated washing. The cushion materials 41 and 42 must be such that they can be easily removed from the case main unit 1 and the upper lid 2 and can be washed whenever stained.

The cushion materials 41 and 42, and in particular, the cushion material 42 has a smooth surface A contacting inner surface of the upper lid 2 and a coarse surface B in touch with a side of the photomask 10. With such arrangement, the cushion material 42 is closely fitted to the upper lid 2 of the case, and they are not easily separated by their own weight. On the other hand, the cushion material 42 comes into contact with the photomask 10 through the coarse surface B. Thus, it is difficult to closely fit it with the photomask 10, and it can be easily separated from the photomask. Therefore, when the upper lid 2 is opened, the cushion material 42 is prevented from falling onto the photomask 10 exposed from the case main unit 1 as it is separated from inner surface. As the result, the cushion material 42 is prevented from contacting working surfaces of the photomask and the photomask pellicle, which may be stained by such contact. When all sides of the cushion material 42 are smooth, or when it is made of such materials that it is closely fitted to the photomask substrate glass, the close contact or the falling of the cushion material 42 with or to the photomask 10 can be prevented by attaching a single-sided tape made of such material as not adherent to glass. Also, for the cushion material 41 placed within the case main unit 1, it is preferable to provide smooth surface on the side facing inner surface and coarse surface on the side touching a side of the photomask 10.

As the case main unit 1 and the upper lid 2, BAYON (trade name; Kureha Chemical Industry Co., Ltd.) having such structure that rubber particles with lower electrical resistance are dispersed in hard resin (matrix). A case made of this material does not show a decrease in charge preventive effect even when washed. If the case is made of such plastics, it is designed as colorless see-through or red see-through or blue see-through. When it is colored in red see-through, the case can also be used for a resist-coated photomask substrate because of the its selectivity of optical wavelength.

A sealing tape made of polyethylene is used to seal between the case main unit 1 and the upper lid 2.

The case of photomask thus obtained does not generate dust during transportation or storage and has good sealing property, and temperature inside the case is kept at constant level. Also, it can be used even after repeated washing.

In the above, description has been given on the case of photomask according to the present invention in connection with an embodiment, while the invention is not limited to the above embodiment, and many changes and modifications can be made without departing from the scope of the invention as set forth herein in the appended claims. This case can also be used for a photomask substrate.

As described above, in the case for photomask according to the present invention, cushion materials are provided on inner bottom of the case main unit and on inner ceiling of the lid so that the photomask or the photomask substrate can be elastically squeezed between the cushion materials. As the result, it is possible to minimize the shaking between the case and the photomask during transportation and to prevent the generation of dust, which may attach to and stain the photomask or the photomask pellicle.

Further, if rubber material having elasticity in itself and not to generate such changes as stain, blur, etc. on the photomask, the photomask substrate, and the photomask pellicle is used as the cushion material, no dust is generated from the cushion materials. By providing at least smooth surface on the side of the cushion material facing inner surface of the cushion material, which is placed on inner ceiling of the lid, by providing coarse surface on the side of the cushion material, which comes into contact with the photomask or the photomask substrate to be accommodated, or by attaching a single-sided tape made of a material not adherent to glass, it is possible to prevent the falling of the cushion materials caused by opening or closing of the lid and to eliminate stain or flaw on the photomask or the photomask substrate.

## Claims

1. A case for a photomask (10), comprising a case main unit (1), having an upper opening for accommodating the photomask (10) or a photomask substrate, and a lid (2) for the opening of the case main unit (1), cushion materials (41, 42) being provided on an inner bottom of the case main unit (1) and on an inner ceiling of the lid (2), and the photomask (10) or the photomask substrate being elastically squeezed between the cushion materials (41, 42), characterized in that
at least the cushion material (42) placed on the inner ceiling of the lid (2) has a smooth surface (A) on a side touching the inner ceiling of the lid (2) and has a coarse surface (B) on a side touching the photomask (10) or the photomask substrate to be accommodated.

2. A case for a photomask (10), comprising a case main unit (1), having an upper opening for accommodating the photomask (10) or a photomask substrate, and a lid (2) for the opening of the case main unit (1), cushion materials (41, 42) being provided on an inner bottom of the case main unit (1) and on an inner ceiling of the lid (2), the photomask (10) or the photomask substrate being elastically squeezed between the cushion materials (41, 42), characterized in that
at least a cushion material (42) placed on the inner ceiling of the lid (2) has a smooth surface on a side facing the inner surface of the lid (2), and a single-sided tape made of a material not adherent to glass is attached on a side touching the photomask (10) or the photomask substrate to be accommodated.

3. A case for a photomask according to Claim 1 or 2, wherein a rubber material having elasticity in itself and generating no change such as stain, blur, etc. on the photomask, photomask substrate and photomask pellicle is used as said cushion materials.

4. A case for a photomask according to any of Claims 1 to 3, wherein a silicone rubber or a fluoro-rubber is used as said cushion materials.

## Patentansprüche

1. Behälter für eine Fotomaske (10) mit einer Behälterhaupteinheit (1) mit einer oberen Öffnung zum Unterbringen der Fotomaske (10) oder eines Fotomaskensubstrats und einem Deckel (2) für die öffnung der Behälterhaupteinheit (1), wobei Polstermaterialien (41, 42) auf einem Innenboden der Behälterhaupteinheit (1) und an einer Innendecke des Deckels (2) vorgesehen sind und die Fotomaske (10) oder das Fotomaskensubstrat zwischen den Polstermaterialien (41, 42) elastisch eingezwängt ist, dadurch gekennzeichnet, daß mindestens das an der Innendecke des Deckels (2) angeordnete Polstermaterial (42) eine glatte Oberfläche (A) auf einer die Innendecke des Deckels (2) berührenden Seite sowie eine grobe bzw. rauhe Oberfläche (B) auf einer die unterzubringende Fotomaske (10) oder das unterzubringende Fotomaskensubstrat berührenden Seite hat.

2. Behälter für eine Fotomaske (10) mit einer Behälterhaupteinheit (1) mit einer oberen Öffnung zum Unterbringen der Fotomaske (10) oder eines Fotomaskensubstrats und einem Deckel (2) für die öffnung der Behälterhaupteinheit (1), wobei Polstermaterialien (41, 42) auf einem Innenboden der Behälterhaupteinheit (1) und an einer Innendecke des Deckels (2) vorgesehen sind und die Fotomaske (10) oder das Fotomaskensubstrat zwischen den Polstermaterialien (41, 42) elastisch eingezwängt ist, dadurch gekennzeichnet, daß mindestens ein an der Innendecke des Deckels (2) angeordnetes Polstermaterial (42) eine glatte Oberfläche auf einer zur Innenfläche des Deckels (2) weisenden Seite hat und ein einseitiges Band, das aus einem nicht an Glas haftenden Material hergestellt ist, auf einer die unterzubringende Fotomaske (10) oder das unterzubringende Fotomaskensubstrat berührenden Seite angeordnet ist.

3. Behälter für eine Fotomaske nach Anspruch 1 oder 2, wobei ein Gummimaterial, das eigenelastisch ist und keine Änderungen wie Verunreinigungen, Flecken usw. auf der Fotomaske, dem Fotomaskensubstrat und einem Fotomaskenhäutchen erzeugt, als Polstermaterialien verwendet wird.

4. Behälter für eine Fotomaske nach einem der Ansprüche 1 bis 3, wobei ein Silikongummi oder ein Fluorgummi als Polstermaterialien verwendet wird.

## Revendications

1. Etui pour un photomasque (10), comprenant une unité d'étui principal (1) ayant une ouverture supérieure pour recevoir le photomasque (10) ou un substrat de photomasque, et un couvercle (2) pour l'ouverture de l'unité d'étui principal (1), des matériaux formant coussins (41, 42) étant prévus sur un fond intérieur de l'unité d'étui principal (1) et sur un fond intérieur du couvercle (2), et le photomasque (10) ou le substrat de photomasque étant serré de manière élastique entre les matériaux formant coussins (41, 42),
caractérisé en ce qu'au moins le matériau formant coussin (42) placé sur le fond intérieur du couvercle (2) a une surface lisse (A) sur un côté touchant le fond intérieur du couvercle (2) et a une surface grossière (B) sur un côté touchant le photomasque (10) ou le substrat de photomasque à recevoir.

2. Etui pour un photomasque (10) comprenant une unité d'étui principal (1) ayant une ouverture supérieure pour recevoir le photomasque (10) ou un substrat de photomasque et un couvercle (2) pour l'ouverture de l'unité d'étui principal (1), des matériaux formant coussins (41, 42) étant prévus sur un fond intérieur de l'unité d'étui principal (1) et sur un fond intérieur du couvercle (2), et le photomasque (10) ou le substrat de photomasque étant élastiquement serré entre les matériaux formant coussins (41, 42),
caractérisé en ce qu'au moins un matériau formant coussin (42) placé sur le fond intérieur du couvercle (2) a une surface lisse d'un côté faisant face à une surface intérieure du couvercle (2), et une bande adhésive d'un seul côté faite d'un matériau non adhérent au verre est fixée sur un côté touchant le photomasque (10) ou le substrat de photomasque à recevoir.

3. Etui pour un photomasque selon la revendication 1 ou 2, dans lequel un matériau caoutchouteux ayant une élasticité en lui-même et ne générant pas de variation telle qu'une tache, un voile, etc. sur le photomasque, le substrat de photomasque et la pellicule de photomasque, est utilisé pour lesdits matériaux formant coussins.

4. Etui pour un photomasque selon l'une quelconque des revendications 1 à 3, dans lequel un caoutchouc silicone ou un caoutchouc fluoré est utilisé pour lesdits matériaux formant coussins.
